(19) Europäisches Patentamt / European Patent Office / Office européen des brevets

(11) **EP 3 776 857 B1**

(12) **FASCICULE DE BREVET EUROPEEN**

(45) Date de publication et mention
de la délivrance du brevet:
**31.05.2023 Bulletin 2023/22**

(21) Numéro de dépôt: **19715523.7**

(22) Date de dépôt: **10.04.2019**

(51) Classification Internationale des Brevets (IPC):
*H03K 5/15* *(2006.01)*   *H04J 3/06* *(2006.01)*
*H04B 1/00* *(2006.01)*

(52) Classification Coopérative des Brevets (CPC):
**H03K 5/15; H04B 1/0003; H04J 3/0697**

(86) Numéro de dépôt international:
**PCT/EP2019/059115**

(87) Numéro de publication internationale:
**WO 2019/197480 (17.10.2019 Gazette 2019/42)**

(54) **SYSTÈME ET PROCÉDÉ DE SYNCHRONISATION TEMPORELLE ENTRE VOIES D'UN SYSTÈME DE RÉCEPTION MULTIVOIES DE SIGNAUX RADIOÉLECTRIQUES**

SYSTEM UND VERFAHREN ZUR ZEITSYNCHRONISATION ZWISCHEN KANÄLEN EINES EMPFANGSSYSTEMS EINES MEHRKANALIGEN FUNKSIGNALS

SYSTEM AND METHOD FOR TIME SYNCHRONIZATION BETWEEN CHANNELS OF A MULTICHANNEL RADIO SIGNAL RECEPTION SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.04.2018 FR 1800299**

(43) Date de publication de la demande:
**17.02.2021 Bulletin 2021/07**

(73) Titulaire: **THALES**
**92400 Courbevoie (FR)**

(72) Inventeurs:
• **BRIAND, Thierry**
 **78551 ELANCOURT (FR)**
• **KERNALEGUEN, Pierre**
 **29238 BREST CEDEX (FR)**

(74) Mandataire: **Lavoix**
**2, place d'Estienne d'Orves**
**75441 Paris Cedex 09 (FR)**

(56) Documents cités:
**FR-A1- 2 900 296   US-B1- 7 058 090
US-B1- 8 035 435**

**Description**

La présente invention concerne un dispositif de synchronisation entre voies adapté à être inséré dans une voie de réception d'un système de réception multivoies de signaux radioélectriques, ainsi qu'un système et un procédé de synchronisation entre voies d'un système de réception multivoies de signaux radioélectriques.

L'invention se situe dans le domaine général des systèmes de réception multivoies de signaux radioélectriques, utilisés dans de nombreux domaines tels que la goniométrie d'amplitude, l'interférométrie, les systèmes radar à synthèse d'ouverture multistatique, des mesures de fréquence et l'imagerie médicale.

De manière connue, dans un système de réception multivoies, chaque voie de réception comprend une chaîne de réception délivrant un signal électrique en entrée d'un convertisseur analogique numérique ayant une fréquence d'échantillonnage associée, et un module d'interfaçage branché en sortie dudit convertisseur analogique numérique et adapté à fournir les échantillons de signal numérisé en entrée d'un module de traitement numérique du signal par paquets d'échantillons, c'est-à-dire avec un minimum de parallélisation. Cela tient au fait qu'un module de traitement numérique du signal comporte un ou plusieurs composants numériques programmables de type FPGA (*Field Programmable Gate Array*) dont la fréquence de travail est bien inférieure à la fréquence d'échantillonnage de la conversion analogique numérique. La réception est dite numérique car le signal est converti d'analogique en numérique pour faire l'objet de traitements numériques.

En particulier pour des applications qui exploitent le déphasage entre voies de réception, par exemple pour l'interférométrie, il est nécessaire que les échantillons issus de chaque voie portent sur la même tranche temporelle des signaux radioélectriques captés en entrée des voies de réception, ou, en d'autres termes, que les paquets d'échantillons soient synchronisés entre voies de réception. De plus, il est nécessaire que la synchronisation entre voies de réception soit stable et reproductible.

Il existe diverses causes possibles de désynchronisation entre voies de réception.

Par exemple, lorsque toutes les voies de réception comportent un convertisseur analogique numérique fonctionnant à une fréquence d'échantillonnage Fe. Il s'agit du cas des chaînes de réception respectant la condition de Shannon, effectuant un filtrage de largeur de bande inférieure à Fe/2 avant la conversion numérique-analogique. La fréquence Fe est très élevée et bien supérieure à la fréquence maximum de fonctionnement des composants numériques programmables. On utilise des modules d'interfaçage, par exemple des démultiplexeurs pouvant comporter un ou plusieurs étages de démultiplexage, qui fournissent des ensembles de P échantillons en parallèle, P étant un nombre entier non nul, à la fréquence Fe/P. Tout éventuel décalage temporel des démultiplexeurs, par exemple lors du démarrage, induit un décalage possible entre échantillons dans les paquets d'échantillons et les sorties des diverses voies de réception ne sont plus synchrones.

Dans ce cas de figure, on connaît dans l'état de la technique des méthodes de synchronisation basées sur l'utilisation d'architectures particulières permettant une distribution de signaux de synchronisation, ayant pour objectif d'effectuer une synchronisation des démultiplexeurs. Des architectures de distribution de signaux de synchronisation en série ou en étoile ont été proposées. De telles solutions sont complexes, et la synchronisation obtenue dépend de la synchronisation d'horloges. La fréquence d'échantillonnage Fe étant très élevée, la période correspondante est très faible, et les temps de propagation et leur dérive ne sont pas négligeables devant cette période. Les systèmes de synchronisation ainsi obtenus peuvent donc devenir instables.

Dans un autre cas de figure, les chaînes de réception ne respectent pas la condition de Shannon, effectuant un filtrage de très large bande instantanée, et les convertisseurs analogique-numérique utilisent des fréquences d'échantillonnage $Fe_i$ différentes pour résoudre la problématique de repliement de spectre due au non-respect de la condition de Shannon. La synchronisation entre voies de réception à base de signaux de synchronisation n'est pas possible dans ce cas.

Après une estimation de valeurs de décalage temporel entre voies, par exemple d'une valeur de décalage temporel entre chaque voie et une voie de référence, dans l'un ou l'autre des cas de figure mentionnés ci-dessus, il est nécessaire d'effectuer une synchronisation effective des échantillons issus des différentes voies et correspondant à une même tranche temporelle.

L'invention a pour objectif de proposer un système de synchronisation entre voies de réception, fonctionnant notamment pour des fréquences d'échantillonnage différentes des convertisseurs analogiques numériques du système de réception multivoies.

À cet effet, l'invention propose un dispositif de synchronisation adapté à être inséré dans une voie de réception d'un système de réception multivoies de signaux radioélectriques entre un module d'interfaçage et un module de traitement numérique du signal, le module d'interfaçage étant adapté à recevoir des échantillons de signal numérisé issus d'un convertisseur analogique-numérique ayant une fréquence d'échantillonnage propre et à fournir des paquets de P échantillons de signal numérisé à une première fréquence. Ce dispositif comporte :

- une mémoire accessible en écriture et en lecture par des accès indépendants, dans laquelle sont mémorisés des paquets d'entrée de *P* échantillons du signal numérisé fournis par le module d'interfaçage,

- un premier ensemble de registres alimentés en entrée par des premiers paquets de *P* échantillons lus dans ladite mémoire, à une deuxième fréquence, chaque paquet de *P* échantillons étant lu à une adresse de lecture, et
- un deuxième ensemble de registres alimentés en entrée par les sorties du premier ensemble de registres et adapté à délivrer des deuxièmes paquets de *P* échantillons au rythme de la deuxième fréquence, un deuxième paquet de *P* échantillons correspondant aux échantillons du premier paquet de *P* échantillons avec un retard d'une période de la deuxième fréquence.

Avantageusement, le dispositif de l'invention permet de synchroniser des échantillons issus de voies fonctionnant à des fréquences d'échantillonnage différentes, tout en compensant des décalages temporels entre ces voies.

Le dispositif de synchronisation selon l'invention peut également présenter une ou plusieurs des caractéristiques ci-dessous, prises indépendamment ou en combinaison.

Le dispositif de synchronisation est tel que les sorties des premier et deuxième ensembles de registres sont branchés en entrée d'un multiplexeur de manière à fournir des paquets doubles de 2*P* échantillons, le multiplexeur étant adapté à former un troisième paquet de *P* échantillons consécutifs parmi les 2*P* échantillons d'entrée du multiplexeur à partir d'une adresse de multiplexage, le dispositif de synchronisation comportant en outre un automate adapté à calculer lesdites adresses de lecture en mémoire et de multiplexage en fonction d'un compteur et d'un décalage temporel par rapport à une voie de réception de référence, le dispositif de synchronisation fournissant en sortie des pluralités de troisièmes paquets de *P* échantillons formant des séries successives comportant chacune un nombre d'échantillons en série correspondant à une même durée, et chaque premier échantillon d'une dite série de ladite voie de réception correspondant temporellement au premier échantillon d'une série correspondante de la voie de réception de référence.

L'automate a une période associée, calculée en fonction de la dite durée, ledit compteur étant incrémenté de manière synchrone entre voies de réception à chaque période d'automate.

L'automate est adapté à calculer ladite adresse de multiplexage pour une valeur de compteur courante en fonction dudit décalage temporel, dudit nombre d'échantillons en série et du nombre *P* d'échantillons par paquet.

L'automate calcule en outre un indicateur de maintien d'adresse de lecture pour une valeur de compteur courante, en fonction d'une comparaison entre une adresse de multiplexage calculée pour ladite valeur de compteur courante, et une adresse de multiplexage calculée pour une valeur de compteur précédente.

L'automate est adapté à calculer ladite adresse de lecture pour la valeur de compteur courante en fonction dudit nombre d'échantillons en série, dudit indicateur de maintien pour la valeur de compteur courante et d'une adresse de lecture calculée pour la valeur de compteur précédente.

Selon un autre aspect, l'invention concerne un système de synchronisation entre voies de réception d'un système de réception multivoies, le système de réception comportant un ensemble de voies de réception de signaux radioélectriques, chaque voie de réception comportant une chaîne de réception délivrant un signal électrique analogique en entrée d'un convertisseur analogique-numérique) ayant une fréquence d'échantillonnage associée, un module d'interfaçage branché en sortie dudit convertisseur analogique numérique et un module de traitement numérique du signal comportant un ou plusieurs composants numériques programmables, le module d'interfaçage étant adapté à fournir des échantillons de signal numérisé en entrée dudit module de traitement numérique du signal en parallèle par paquets. Ce système est tel que chaque voie de réception comporte un dispositif de synchronisation tel que brièvement décrit ci-dessus.

Selon une caractéristique, le système comporte en outre un module de comptage adapté à fournir de manière synchronisée une valeur de compteur à chaque dispositif de synchronisation de chaque voie de réception.

Selon un autre aspect, l'invention concerne un procédé de synchronisation entre voies de réception d'un système de réception multivoies de signaux radioélectriques mis en oeuvre dans dispositif de synchronisation adapté à être inséré dans une voie de réception d'un système de réception multivoies de signaux radioélectriques entre un module d'interfaçage et un module de traitement numérique du signal, le module d'interfaçage étant adapté à recevoir des échantillons de signal numérisé issus d'un convertisseur analogique numérique ayant une fréquence d'échantillonnage propre et à fournir des paquets de *P* échantillons de signal numérisé à une première fréquence . Ce procédé comporte :

- la mémorisation dans une mémoire accessible en écriture et en lecture par des accès indépendants, dans laquelle sont mémorisés des paquets d'entrée de *P* échantillons du signal numérisé fournis par un module d'interfaçage à une première fréquence,
- l'obtention de premiers paquets de *P* échantillons dans un premier ensemble de registres alimentés en entrée par des premiers paquets de *P* échantillons lus dans ladite mémoire, à une deuxième fréquence, chaque premier paquet de *P* échantillons étant lu à une adresse de lecture, et
- l'obtention de deuxièmes paquets de *P* échantillons dans un deuxième ensemble de registres alimentés en entrée par les sorties du premier ensemble de registres et adapté à délivrer des deuxièmes paquets de *P* échantillons au rythme de la deuxième fréquence, un deuxième paquet de $P$ échantillons correspondant aux échantillons du premier paquet de $P$ échantillons avec un retard d'une période de la deuxième fréquence.

Selon une caractéristique, le procédé de synchronisation comporte en outre des étapes de :

- réception et mémorisation d'un décalage temporel à appliquer,
- obtention d'une valeur de compteur courante, et calcul d'une adresse de lecture courante et d'une adresse de multiplexage courante en fonction de la valeur de compteur courante et du décalage temporel à appliquer,
- obtention d'un dit premier paquet d'échantillons d'un premier ensemble de registres et d'un dit deuxième paquet d'échantillons d'un deuxième ensemble de registres en appliquant l'adresse de lecture courante,
- extraction d'un troisième paquet de $P$ échantillons consécutifs à partir d'un paquet double de $2P$ échantillons formé par les premier et deuxième paquets, en utilisant ladite adresse de multiplexage.

D'autres caractéristiques et avantages de l'invention ressortiront de la description qui en est donnée ci-dessous, à titre indicatif et nullement limitatif, en référence aux figures annexées, parmi lesquelles :

- la figure 1 illustre schématiquement un système de synchronisation entre voies de réception d'un système de réception multivoies selon un mode de réalisation ;
- la figure 2 illustre en détail un mode de réalisation d'un dispositif de synchronisation pour une voie de réception ;
- la figure 3 représente schématiquement des paquets d'échantillons issus d'un dispositif d'interfaçage d'une voie de réception ;
- les figures 4 et 5 représentent schématiquement un exemple de paquets d'échantillons issus de deux voies de réception, avant et après application de la synchronisation ;
- la figure 6 illustre schématiquement des premiers et deuxièmes paquets d'échantillons utilisés pour obtenir une série d'échantillons selon un mode de réalisation ;
- les figures 7 et 8 illustrent, dans un exemple, des paquets d'échantillons issus des premier et deuxième ensembles de registres du dispositif de synchronisation, et des séries synchronisées obtenues ;
- la figure 9 est un synoptique des principales étapes d'un procédé de synchronisation selon un mode de réalisation.

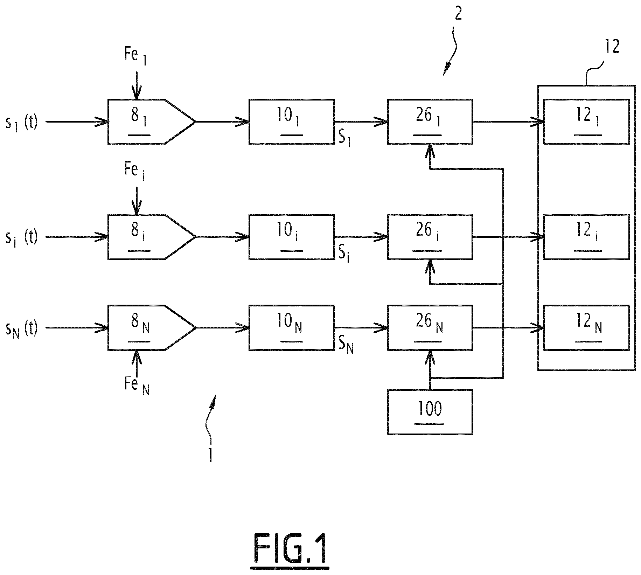

La figure 1 illustre un système 1 de réception multivoies mettant en oeuvre un système de synchronisation 2 entre les voies.

Le système 1 de réception multivoies de signaux radioélectriques comprend N voies de réception $V_1$ à $V_N$, l'une quelconque des voies de réception étant référencée ci-après $V_i$, avec i compris entre 1 et N.

Chaque voie de réception comprend une chaîne de réception analogique non représentée en figure 1, un convertisseur analogique-numérique ou CAN $8_i$, un module d'interfaçage $10_i$, un dispositif de synchronisation $26_i$ et un module de traitement numérique de signal $12_i$ associé à la voie de réception, faisant partie d'un module de traitement numérique 12. Le module 12 est en outre adapté à effectuer des calculs numériques sur les éléments issus des différents modules de traitement numérique de signal $12_i$, par exemple des calculs de corrélation.

Le CAN $8_i$ fournit des échantillons numériques du signal $S_i(t)$ délivré par la chaîne de réception analogique au module d'interfaçage $10_i$ au rythme de la fréquence d'échantillonnage $Fe_i$ dudit CAN. Les échantillons numériques du signal sont simplement désignés par la suite par échantillons.

Dans le mode de réalisation décrit ici, toutes les fréquences d'échantillonnage $Fe_i$ sont différentes.

La fréquence d'échantillonnage $Fe_i$ est bien supérieure à la fréquence maximale de fonctionnement des composants numériques programmables (FPGA) situés en aval des CAN, en particulier dans le module de traitement numérique de signal 12.

Le module d'interfaçage $10_i$ a donc pour fonction de transformer le flux d'échantillons série au rythme $Fe_i$ en flux série de paquets de $P$ échantillons en parallèle à la première fréquence $\dfrac{Fe_i}{P}$ , $P$ étant un nombre entier non nul, cette première fréquence étant plus lente et compatible avec la deuxième fréquence ou fréquence de travail des composants numériques programmables $F_T$. On désigne par $S_i(t)$ le signal numérique délivré par le module d'interfaçage $10_i$, issu d'un signal analogique $s_i(t)$ correspondant.

Le module d'interfaçage $10_i$ est, dans un mode de réalisation, un démultiplexeur à un ou plusieurs étages de démultiplexage, fournissant des paquets de $P$ échantillons en parallèle. Les démultiplexeurs $10_i$ des différentes voies de réception ne sont pas synchronisés, et ne sont pas synchronisables car les fréquences $Fe_i$ sont différentes, et par conséquent les valeurs $\dfrac{Fe_i}{P}$ sont également différentes.

Chaque voie de réception du système comprend un dispositif de synchronisation $26_i$ branché entre le module d'interfaçage $10_i$ et le module de traitement numérique $12_i$.

Ce dispositif de synchronisation $26_i$ a pour fonction, à partir d'un flux d'entrée série de paquets de $P$ échantillons successifs passés en parallèle, les échantillons étant obtenus à une fréquence d'échantillonnage $Fe_i$ et ayant subi un possible décalage de temps lié à la voie $i$, de former des séries de $N_i$ échantillons successifs, toujours formatées en paquets de $P$ échantillons successifs en parallèle, dont le premier échantillon desdites séries correspond, quel que soit $i$, au même temps absolu, c'est-à-dire au temps courant dans le flux d'entrée corrigé dudit possible décalage de temps.

Chaque dispositif de synchronisation $26_i$ reçoit en entrée une valeur de décalage temporel $\Delta\tau_{r,i}$ entre la voie $V_i$ et la voie de référence $V_r$, calculé par ailleurs par un procédé adapté, de façon à fournir des séries d'échantillons recalés temporellement entre voies aux modules $12_i$.

Le module 100 est dans le mode de réalisation préféré un module de comptage commun à tous les dispositifs de synchronisation $26_i$, qui distribue une même valeur de compteur à un instant donné à chaque dispositif de synchronisation.

En variante, le module de comptage 100 est adapté à effectuer une synchronisation des compteurs des dispositifs de synchronisation $26_i$, par exemple par une remise à zéro initiale, de façon à ce que chacun des compteurs délivre une même valeur de compteur à chaque dispositif de synchronisation $26_i$.

Chaque module de traitement numérique $12_i$ peut, par exemple, réaliser une transformée de Fourier discrète (TFD) sur les $N_i$ échantillons successifs d'une série, correspondant à une durée de signal $\Delta T$ qui est la même pour toutes les voies de réception. Ainsi, quel que soit i :

$$\frac{N_i}{Fe_i} = \Delta T \qquad \text{(EQ1)}$$

En particulier pour des applications interférométriques, il est nécessaire que les séries de $N_i$ échantillons successifs pour des valeurs de $i$ différentes, correspondent toutes au même intervalle de temps absolu pour que le déphasage entre fin de voies, entre deux voies données, soit représentatif de celui en sortie des antennes desdites deux voies sur un même signal incident.

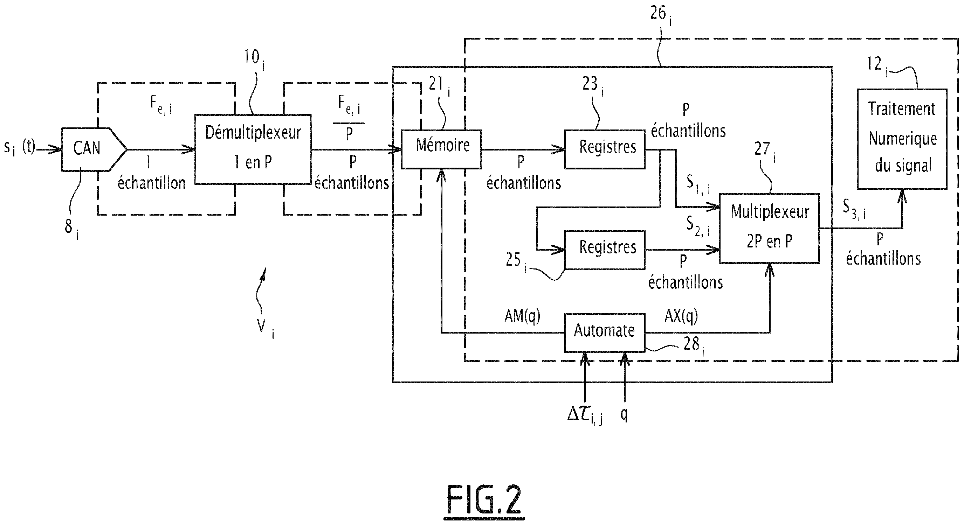

La figure 2 illustre en détail un dispositif de synchronisation $26_i$ faisant partie de la voie de réception $V_i$.

Le dispositif de synchronisation $26_i$ reçoit en entrée des paquets de $P$ échantillons à la première fréquence $\frac{Fe_i}{P}$, et fournit en sorties des séries de $N_i$ échantillons, par paquets de P échantillons.

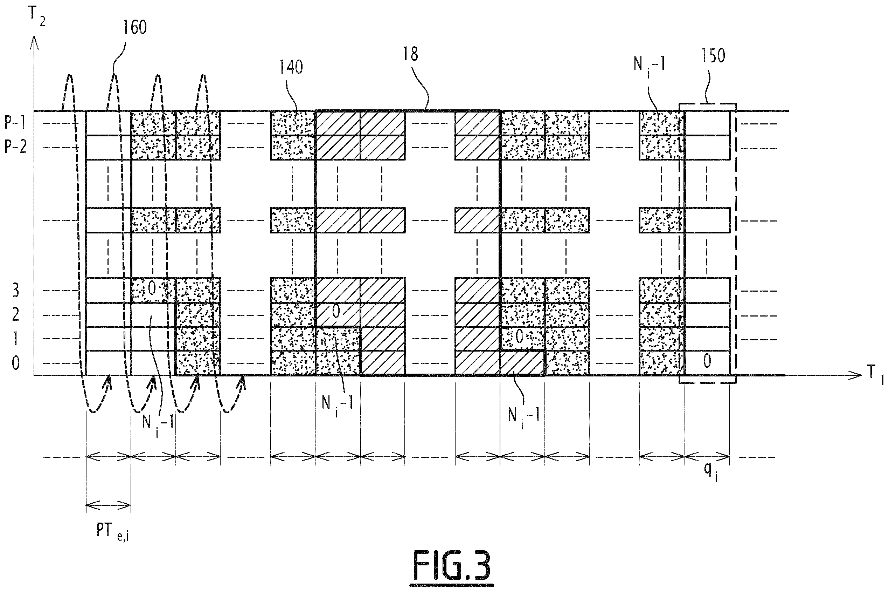

La figure 3 illustre un premier problème à résoudre du fait que le nombre $N_i$ n'est pas, généralement, un multiple de $P$.

La figure 3 illustre la parallélisation du flux d'échantillons en $P$ lignes parallèles, réalisée par le démultiplexeur $10_i$. Chaque échantillon est symbolisé par une case 140. Ces échantillons sont illustrés dans un diagramme à deux axes temporels $T_1$ et $T_2$. Les paquets 150 de $P$ échantillons sont référencés par un indice $q_i$. La durée correspondant à un paquet est de $PTe_i = \frac{P}{Fe_i}$. Les flèches recourbées 160 indiquent la continuité des échantillons dans le temps.

Les séries 18 à fournir en sortie sont des séries de $N_i$ échantillons, référencées par un indice $k_i$, montrées en en traits épais. Cependant, le nombre $N_i$ n'étant pas un multiple de $P$, chaque série 18 ne commencent pas systématiquement par un paquet de P échantillons lui appartenant intégralement, comme illustré à la figure 3 par l'échantillon d'indice 0 de chaque paquet. La position du premier échantillon d'une série 18 dans un paquet de $P$ échantillons 150 évolue dans le temps, et dépend du reste $R_i$ de la division euclidienne de $N_i$ par $P$.

Le nombre $N_i$ s'écrit sous la forme :

$$N_i = M \times P + R_i \qquad \text{(EQ 2)}$$

avec $a < R_i < P$, $M$ étant la partie entière de $N_i$ divisé par $P$, $M = \text{Ent}\left(\frac{N_i}{P}\right)$, Ent(.) étant la fonction partie entière, et $R_i$ le reste de la division euclidienne de $N_i$ par $P$.

En utilisant l'opérateur modulo Mod(.,.) on écrit :

$$R_i = \text{Mod}(N_i, P) \qquad \text{(EQ3)}$$

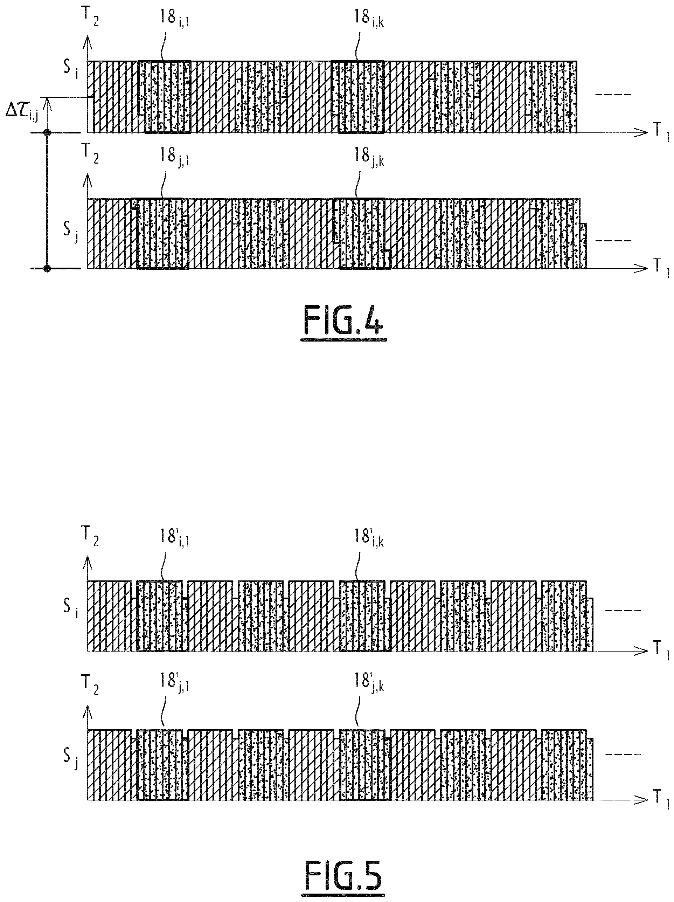

Les figures 4 et 5 illustrent chacune des échantillons issus de deux voies de réception $V_i$ et $V_j$, à synchroniser entre elles, selon un double axe temporel de manière analogue à la représentation de la figure 3, par paquets de $P$ échantillons correspondant à une même abscisse sur l'axe $T_1$.

Les fréquences d'échantillonnage sont respectivement égales à $Fe_i$ et $Fe_j$, elles sont différentes, et de plus il y un décalage temporel $\Delta \tau_{i,j}$ entre les deux voies, comme illustré à la figure 4.

Une de ces deux voies de réception est la voie de référence.

La voie de référence est choisie comme étant la voie qui véhicule le signal reçu avec un retard de temps par rapport à toutes les autres voies.

Les séries d'échantillons $18_{i;1}$ et $18_{j,1}$ comprenant respectivement $N_i$ et $N_j$ échantillons sont à synchroniser en sortie comme expliqué ci-dessus et comme illustré schématiquement par la figure 5.

En effet, les séries référencées $18'_{i,1}$ et $18'_{j,1}$ sont composées de mêmes échantillons de signal que les séries correspondantes respectives $18_{i,1}$ et $18_{j,1}$ de la figure 4. Les séries $18'_{i,1}$ et $18'_{j,1}$ sont obtenues en sortie des dispositifs de synchronisation $26_i$ et $26_j$ mis en oeuvre sur chacune des voies $V_i$ et $V_j$.

Comme illustré à la figure 2, le dispositif de synchronisation $26_i$ d'une voie de réception $V_i$ comporte une mémoire $21_i$ accessible en écriture et en lecture par des accès indépendants, dans laquelle sont mémorisés des paquets 150 d'entrée de $P$ échantillons du signal $S_i$ numérisé fournis par le module $10_i$, écrits dans la mémoire $21_i$ à la première fréquence $Fe_i/P$.

Le dispositif de synchronisation comprend également deux ensembles de registres $23_i$ et $25_i$, chaque ensemble comprenant un nombre de registres égal à $P$ fois le nombre de bits des échantillons. Le premier ensemble de registres $23_i$ est alimenté par des premiers paquets de $P$ échantillons lus dans la mémoire $21_i$ à la deuxième fréquence $F_T$, qui est la fréquence de travail.

Le deuxième ensemble de registres $25_i$ est branché en sortie du premier ensemble de registres $23_i$ et est adapté à mémoriser des deuxièmes paquets de $P$ échantillons. Chaque deuxième paquet est décalé d'une période d'horloge $1/F_T$ par rapport à un premier paquet de $P$ échantillons correspondant.

En notant $S_{1,i}$ le signal numérisé de sortie du premier ensemble de registres $23_i$ et $S_{2,i}$ le signal numérisé de sortie du deuxième ensemble de registres $25_i$ la relation suivante est vérifiée :

$$S_{2,i}(t) = S_{1,i}\left(t - \frac{1}{F_t}\right) \quad \text{(EQ4)}$$

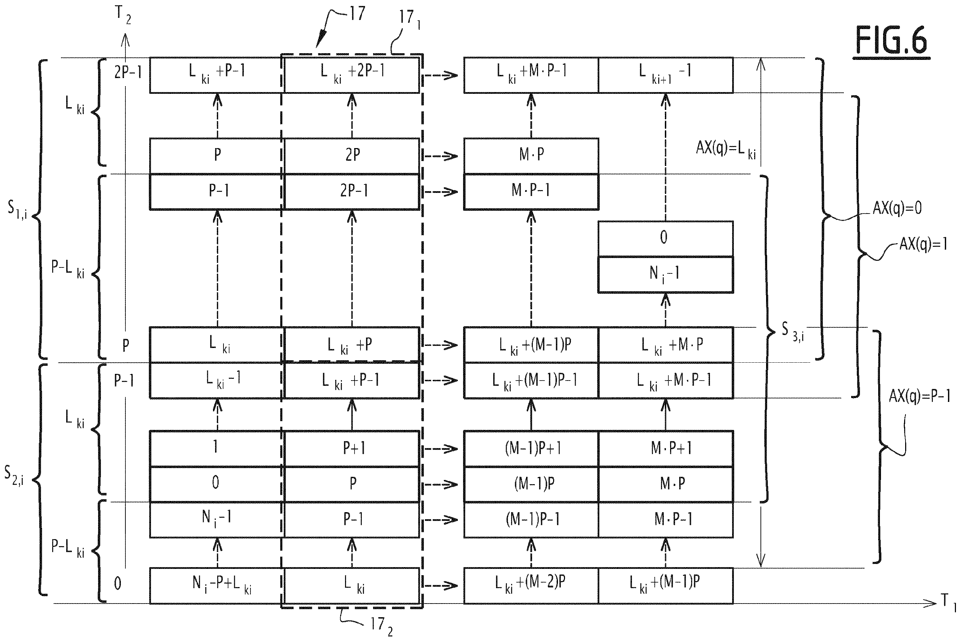

En d'autres termes, et comme illustré à la figure 6, à un instant donné, les sorties des deux ensembles de registres $25_i$ et $23_i$ forment un paquet double 17 de $2P$ échantillons successifs. Par exemple, le paquet 17 est formé des paquets $17_1$ et $17_2$. Le paquet $17_2$ d'échantillons issus du deuxième ensemble de registres $25_i$ comporte les échantillons d'indices $\{L_{k_i}, \dots, L_{k_i} + P - 1\}$ et le paquet $17_1$ d'échantillons issus du premier ensemble de registres $23_i$ comporte les échantillons d'indices $\{L_{k_i} + P, \dots, L_{k_i} + 2P - 1\}$.

Les sorties des premier et deuxième ensembles de registres sont branchés en entrée d'un multiplexeur $27_i$, adapté à sélectionner $P$ échantillons consécutifs parmi les $2P$ échantillons d'un paquet double en utilisant une adresse de multiplexage, pour former un troisième paquet de $P$ échantillons.

Le dispositif de synchronisation $26_i$ comprend un automate $28_i$ qui est un module programmable comportant au moins un processeur de calcul et un élément de mémoire adapté à mémoriser des valeurs de paramètres.

Dans un mode de réalisation, l'automate est réalisé à l'aide de circuits numériques. Dans un autre mode de réalisation, l'automate est réalisé dans le FPGA dédié à la réalisation du module $12_i$.

L'automate $28_i$ qui reçoit en entrée la valeur de décalage temporel $\Delta \tau_{i,j}$ à appliquer et une valeur $q$ d'un compteur courant à la deuxième fréquence $F_T$ et comptant en permanence cycliquement de 0 à $Q_A - 1$, $Q_A$ correspondant au nombre d'états du compteur qui vaut précisément $(M + 1) \times P$, la période de ce cycle valant donc :

$$T_A = \frac{Q_A}{F_T} = P \times \Delta T \quad \text{(EQ5)}$$

En pratique, il est usuel de choisir $P = 2^B$ où $B$ est une valeur entière, par exemple $B = 3$.

En variante, la valeur de compteur $q$ est calculée par l'automate $28_i$ à partir d'une horloge interne de cet automate (non représentée en figure 2).

L'automate $28_i$ est adapté à calculer, en temps réel, pour chaque valeur courante $q$, une adresse de lecture dans la mémoire $21_i$, $AM(q)$, et une adresse de multiplexage du multiplexeur $27_i$, $AX(q)$. Il est à noter que l'indice $i$ a été omis pour simplifier les notations.

Les adresses de multiplexage sont comprises entre 0 et P - 1, et sont calculées modulo $P$. Plusieurs exemples d'adresses de multiplexage *AX(q)* sont montrés à la figure 6.

L'automate 28ᵢ calcule également un indicateur de maintien $I_{AM}(q)$ de l'adresse de lecture en mémoire courante, qui est mis en oeuvre lorsqu'une adresse de multiplexage courante est inférieure à une adresse de multiplexage précédente.

Les valeurs calculées par l'automate 28ᵢ sont, dans le mode de réalisation préféré, données par les formules suivantes.

À l'initialisation :

$$I_{AM}(q - 1) = 0 \qquad \text{(EQ6)}$$

$$AM(q - 1) = \text{Ent}\left(\frac{\Delta\tau_{i,j}}{P}\right) \text{ si } \Delta\tau_{i,j} > 0 \quad \text{(EQ7)}$$

$$AM(q - 1) = -1 \quad \text{si } \Delta\tau_{i,j} = 0 \text{ (EQ8)}$$

Après initialisation, les formules récurrentes suivantes sont appliquées :

$$AX(q) = \text{Mod}\left(\text{Ent}\left(\frac{q}{P}\right) \times (P - R_i) - \text{Mod}\left(\Delta\tau_{i,j}, P\right), P\right) \qquad \text{(EQ9)}$$

$$I_{AM}(q) = 0 \text{ si } AX(q) \geq AX(q - 1) \qquad \text{(EQ10)}$$

$$I_{AM}(q) = 1 \text{ si } AX(q) < AX(q - 1) \qquad \text{(EQ11)}$$

$$AM(q) = \text{Mod}(AM(q - 1) + 1 - I_{AM}(q), N_i) \qquad \text{(EQ12)}$$

Le décalage temporel $\Delta\tau_{i,j}$ est une donnée d'entrée prise en compte à chaque début de période d'automate $T_A$.

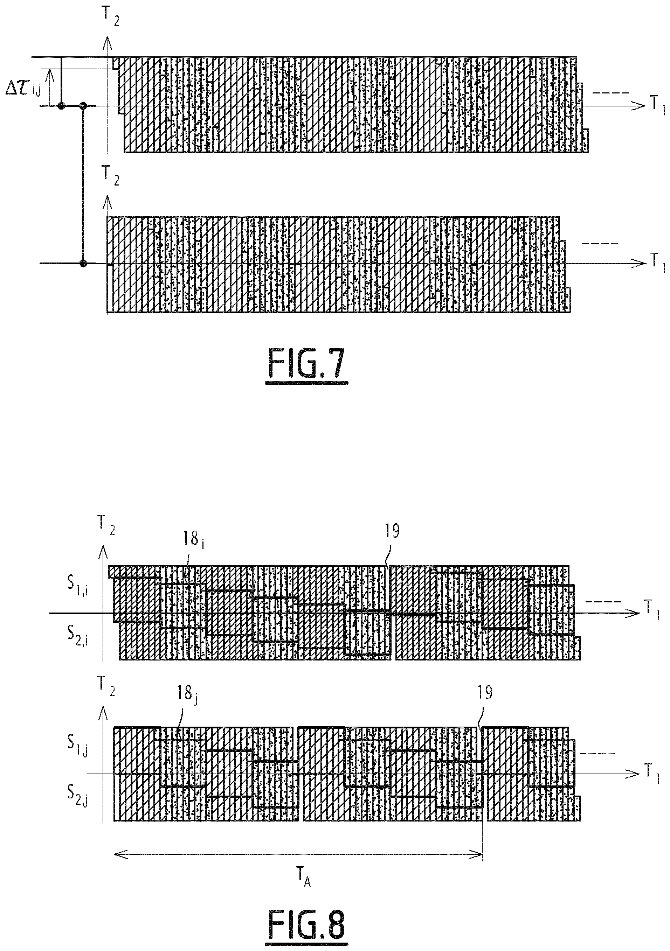

Les figures 7 et 8 illustrent un exemple de synchronisation entre deux voies sur une période d'automate $T_A$.

Dans l'exemple, *P* = 8, *N*ᵢ = 62, *N*ⱼ = 63 et $\Delta\tau_{i,j}$ valant sensiblement $\frac{14}{8F_T}$ ou $\frac{14}{Fe_i}$.

Les séries synchronisées 18ᵢ, 18ⱼ sont entourées d'un cadre en traits épais à la figure 8. Les colonnes 19 de la figure 8 indiquent le maintien de l'adresse de lecture en mémoire précédente.

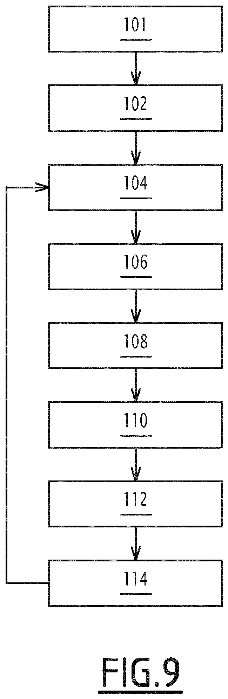

La figure 9 est un logigramme des principales étapes d'un procédé de synchronisation selon un mode de réalisation de l'invention.

Le procédé est mis en oeuvre en parallèle sur toutes les voies de réception. Les étapes décrites ci-après concernent une seule voie de réception Vᵢ. Les mêmes étapes sont effectuées sur toutes les voies de réception.

Le procédé comprend une première étape 101 de réception et mémorisation du décalage temporel $\Delta\tau_{r,i}$ par rapport à la voie de référence à appliquer.

À l'étape d'initialisation 102, les valeurs d'adresse de lecture *AM(q)*, d'adresse de multiplexage *AX(q)* et d'indicateur de maintien $I_{AM}(q)$ sont initialisées et mémorisées selon les formules (EQ6) à (EQ8) ci-avant définies.

À l'étape 104, la valeur *q* de compteur courant est reçue.

Comme expliqué précédemment, chaque automate de chaque voie de réception utilise la même valeur de compteur courante q au même instant temporel, grâce à la mise en oeuvre du module de comptage 100.

À l'étape 106 est calculée et mémorisée l'adresse de multiplexage *AX(q)* courante, selon la formule (EQ9), et à l'étape suivante 108 l'adresse de multiplexage *AX(q)* courante est comparée à l'adresse de multiplexage précédente mémorisée.

L'indicateur de maintien $I_{AM}(q)$ est ensuite calculé et mémorisé à l'étape 110, le calcul étant effectué en fonction du résultat de l'étape de comparaison précédente selon les formules (EQ10) et (EQ11). L'adresse de lecture *AM(q)* est également calculée selon la formule (EQ12), et mémorisée.

Ensuite on obtient à l'étape 112, à partir des premier ensemble de registres et deuxième ensemble de registres, les paquets de *P* échantillons correspondant à l'adresse de lecture *AM(q)* calculée.

Ensuite à l'étape 114 est appliquée l'adresse de multiplexage calculée *AX(q)* pour obtenir un troisième paquet de *P* échantillons faisant partie de la série courante de $N_i$ échantillons.

Le procédé retourne ensuite à l'étape 104 de réception d'une valeur de compteur courante.

En d'autres termes, à chaque coup d'horloge de deuxième fréquence $F_T$, la valeur de q s'incrémente de 1, et on calcule *Ax(q), $I_{AM}(q)$* et *AM(q).*

Ces valeurs calculées sont ensuite appliquées pour la formation d'une série de $N_i$ échantillons comme expliqué en détail ci-dessus. L'invention a été décrite ci-dessus dans le cas particulier de voies de réception ayant des fréquences d'échantillonnage différente.

Il est entendu que le dispositif, système et procédé de l'invention s'appliquent également dans le cas dans lequel chaque voie de réception comporte un convertisseur analogique-numérique fonctionnant à une même fréquence d'échantillonnage Fe.

## Revendications

1. Dispositif de synchronisation ($26_i$) adapté à être inséré dans une voie de réception d'un système de réception multivoies de signaux radioélectriques entre un module d'interfaçage ($10_i$) et un module de traitement numérique du signal ($12_i$), le module d'interfaçage étant adapté à recevoir des échantillons de signal numérisé issus d'un convertisseur analogique-numérique ayant une fréquence d'échantillonnage propre ($Fe_i$) et à fournir des paquets de *P* échantillons de signal numérisé à une première fréquence ($Fe_i/P$), le dispositif étant **caractérisé en ce qu'**il comporte :

   - une mémoire ($21_i$) accessible en écriture et en lecture par des accès indépendants, dans laquelle sont mémorisés des paquets d'entrée de *P* échantillons du signal numérisé fournis par le module d'interfaçage ($10_i$),
   - un premier ensemble de registres ($23_i$) alimentés en entrée par des premiers paquets de *P* échantillons lus dans ladite mémoire ($21_i$), à une deuxième fréquence ($F_T$), chaque paquet de *P* échantillons étant lu à une adresse de lecture *(AM(q)),* et
   - un deuxième ensemble de registres ($25_i$) alimentés en entrée par les sorties du premier ensemble de registres et adapté à délivrer des deuxièmes paquets de *P* échantillons au rythme de la deuxième fréquence ($F_T$), un deuxième paquet de *P* échantillons correspondant aux échantillons du premier paquet de *P* échantillons avec un retard d'une période de la deuxième fréquence ($F_T$).

2. Dispositif de synchronisation selon la revendication 1, dans lequel :

   les sorties des premier et deuxième ensembles de registres sont branchés en entrée d'un multiplexeur ($27_i$) de manière à fournir des paquets doubles de 2*P* échantillons, le multiplexeur ($27_i$) étant adapté à former un troisième paquet de *P* échantillons consécutifs parmi les 2*P* échantillons d'entrée du multiplexeur ($27_i$) à partir d'une adresse de multiplexage (*AX(q)*),
   le dispositif de synchronisation comportant en outre un automate ($28_i$) adapté à calculer lesdites adresses de lecture en mémoire *(AM(q))* et de multiplexage (*AX(q)*) en fonction d'un compteur (*q*) et d'un décalage temporel par rapport à une voie de réception de référence ($\Delta\tau_{i,j}$),
   le dispositif de synchronisation fournissant en sortie des pluralités de troisièmes paquets de *P* échantillons formant des séries successives comportant chacune un nombre d'échantillons en série correspondant à une même durée, et chaque premier échantillon d'une dite série de ladite voie de réception correspondant temporellement au premier échantillon d'une série correspondante de la voie de réception de référence.

3. Dispositif de synchronisation selon la revendication 2, dans lequel ledit automate a une période associée ($T_A$), calculée en fonction de la dite durée ($\Delta T$), ledit compteur (*q*) étant incrémenté de manière synchrone entre voies de réception à chaque période d'automate.

4. Dispositif de synchronisation selon l'une des revendications 2 ou 3, dans lequel ledit automate est adapté à calculer ladite adresse de multiplexage (*AX(q)*) pour une valeur de compteur courante (*q*) en fonction dudit décalage temporel ($\Delta\tau_{i,j}$), dudit nombre d'échantillons en série ($N_i$) et du nombre *P* d'échantillons par paquet.

5. Dispositif de synchronisation selon la revendication 4, dans lequel ledit automate calcule en outre un indicateur de maintien d'adresse de lecture ($I_{AM}(q)$) pour une valeur de compteur courante (*q*), en fonction d'une comparaison entre une adresse de multiplexage (*AX(q)*) calculée pour ladite valeur de compteur courante, et une adresse de multiplexage (*AX(q* - 1)) calculée pour une valeur de compteur précédente.

**6.** Dispositif de synchronisation selon la revendication 5, dans lequel ledit automate est adapté à calculer ladite adresse de lecture ($AM(q)$) pour la valeur de compteur courante ($q$) en fonction dudit nombre d'échantillons en série, dudit indicateur de maintien ($I_{AM}(q)$) pour la valeur de compteur courante ($q$) et d'une adresse de lecture ($AM(q - 1)$) calculée pour la valeur de compteur précédente.

**7.** Système de synchronisation entre voies d'un système de réception multivoies de signaux radioélectriques, le système de réception comportant un ensemble de voies de réception de signaux radioélectriques, chaque voie de réception ($V_i$) comportant une chaîne de réception délivrant un signal électrique analogique en entrée d'un convertisseur analogique-numérique ($8_i$) ayant une fréquence d'échantillonnage ($Fe_i$) associée, un module d'interfaçage ($10_i$) branché en sortie dudit convertisseur analogique numérique ($4_i$) et un module de traitement numérique du signal ($12_i$) comportant un ou plusieurs composants numériques programmables, le module d'interfaçage ($10_i$) étant adapté à fournir des échantillons de signal numérisé en entrée dudit module de traitement numérique du signal ($12_i$) en parallèle par paquets,
**caractérisé en ce que** chaque voie de réception ($V_i$) comporte un dispositif de synchronisation ($26_i$) selon l'une des revendications 1 à 6.

**8.** Système de synchronisation selon la revendication 7, comportant en outre un module de comptage (100) adapté à fournir de manière synchronisée une valeur de compteur à chaque dispositif de synchronisation de chaque voie de réception.

**9.** Procédé de synchronisation entre voies d'un système de réception multivoies de signaux radioélectriques mis en oeuvre dans un dispositif de synchronisation ($26_i$) adapté à être inséré dans une voie de réception d'un système de réception multivoies de signaux radioélectriques entre un module d'interfaçage ($10_i$) et un module de traitement numérique du signal ($12_i$), le module d'interfaçage étant adapté à recevoir des échantillons de signal numérisé issus d'un convertisseur analogique numérique ayant une fréquence d'échantillonnage propre ($Fe_i$) et à fournir des paquets de $P$ échantillons de signal numérisé à une première fréquence ($Fe_i/P$), le procédé étant **caractérisé en ce qu'**il comporte :

- la mémorisation dans une mémoire accessible en écriture et en lecture par des accès indépendants, dans laquelle sont mémorisés des paquets d'entrée de $P$ échantillons du signal numérisé fournis par le module d'interfaçage ($10_i$) à la première fréquence ($Fe_i/P$),
- l'obtention de premiers paquets de $P$ échantillons dans un premier ensemble de registres (23) alimentés en entrée par des premiers paquets de $P$ échantillons lus dans ladite mémoire ($21_i$), à une deuxième fréquence ($F_T$), chaque premier paquet de $P$ échantillons étant lu à une adresse de lecture ($AM(q)$), et
- l'obtention de deuxièmes paquets de P échantillons dans un deuxième ensemble de registres ($25_i$) alimentés en entrée par les sorties du premier ensemble de registres et adapté à délivrer des deuxièmes paquets de $P$ échantillons au rythme de la deuxième fréquence ($F_T$), un deuxième paquet de $P$ échantillons correspondant aux échantillons du premier paquet de $P$ échantillons avec un retard d'une période de la deuxième fréquence ($F_T$).

**10.** Procédé de synchronisation selon la revendication 9, comportant en outre des étapes de :

- réception et mémorisation d'un décalage temporel à appliquer,
- obtention d'une valeur de compteur courante, et calcul d'une adresse de lecture courante ($AM(q)$) et d'une adresse de multiplexage ($AX(q)$) courante en fonction de la valeur de compteur courante et du décalage temporel à appliquer,
- obtention d'un dit premier paquet d'échantillons d'un premier ensemble de registres et d'un dit deuxième paquet d'échantillons d'un deuxième ensemble de registres en appliquant l'adresse de lecture courante ($AM(q)$),
- extraction d'un troisième paquet de $P$ échantillons consécutifs à partir d'un paquet double de 2$P$ échantillons formé par les premier et deuxième paquets, en utilisant ladite adresse de multiplexage ($AX(q)$).

**Patentansprüche**

**1.** Synchronisationsvorrichtung ($26_i$), die angepasst ist, in einen Empfangskanal eines Mehrkanalempfangssystems für Funksignale zwischen einem Schnittstellenmodul ($10_i$) und einem Modul zur digitalen Signalverarbeitung ($12_i$) eingefügt zu werden, wobei das Schnittstellenmodul angepasst ist, um digitalisierte Signalabtastungen zu empfangen, die von einem Analog-Digital-Wandler mit einer eigenen Abtastfrequenz ($Fe_i$) stammen, und Pakete aus $P$ digitalisierten Signalabtastungen mit einer ersten Frequenz ($Fe_i/P$) zu liefern, wobei die Vorrichtung **dadurch ge-**

**kennzeichnet ist, dass** sie Folgendes umfasst:

- einen Speicher ($21_i$), auf den durch unabhängige Zugriffe schreibend und lesend zugegriffen werden kann, in dem Eingabepakete von $P$ Abtastwerten des digitalisierten Signals gespeichert sind, die von dem Schnittstellenmodul ($10_i$) geliefert werden,
- eine erste Gruppe von Registern ($23_i$), die am Eingang mit ersten Paketen von $P$ Abtastwerten versorgt werden, die mit einer zweiten Frequenz ($F_T$) aus dem Speicher ($21_i$) gelesen werden, wobei jedes Paket von $P$ Abtastwerten an einer Leseadresse ($AM(q)$) gelesen wird, und
- eine zweite Gruppe von Registern ($25_i$), die am Eingang von den Ausgängen der ersten Gruppe von Registern gespeist werden und angepasst sind, um zweite Pakete von $P$ Abtastwerten im Rhythmus der zweiten Frequenz ($F_T$) zu liefern, wobei ein zweites Paket von $P$ Abtastwerten den Abtastwerten des ersten Pakets von $P$ Abtastwerten mit einer Verzögerung um eine Periode der zweiten Frequenz ($F_T$) entspricht.

2. Synchronisationsvorrichtung nach Anspruch 1, wobei:

die Ausgänge der ersten und der zweiten Gruppe von Registern am Eingang eines Multiplexers ($27_i$) angeschlossen sind, um Doppelpakete von 2P Abtastwerten zu liefern, wobei der Multiplexer ($27_i$) angepasst ist, um ein drittes Paket von $P$ aufeinanderfolgenden Abtastwerten aus den *2P* Eingangsabtastwerten des Multiplexers (27;) ausgehend von einer Multiplexeradresse *(AX(q))* zu bilden,
die Synchronisationsvorrichtung ferner umfassend einen Automaten ($28_i$), der angepasst ist, die Speicherlese- und Multiplexadressen ($AM(q)$) abhängig von einem Zähler *(AX(q))* und einer Zeitverschiebung in Bezug auf einen Referenzempfangskanal ($\Delta\tau_{i,j}$) zu berechnen,
wobei die Synchronisationsvorrichtung am Ausgang eine Vielzahl von dritten Paketen von $P$ Abtastwerten liefert, die aufeinanderfolgende Serien bilden, die jeweils eine Anzahl von seriellen Abtastwerten umfassen, die einer gleichen Dauer entsprechen, und wobei jeder erste Abtastwert einer Serie des Empfangskanals zeitlich dem ersten Abtastwert einer entsprechenden Serie des Referenzempfangskanals entspricht.

3. Synchronisationsvorrichtung nach Anspruch 2, wobei mit dem Automat eine Periode ($T_A$) assoziiert ist, die abhängig von der Dauer ($\Delta T$) berechnet wird, wobei der Zähler ($q$) synchron zwischen Empfangskanälen bei jeder Automatenperiode inkrementiert wird.

4. Synchronisationsvorrichtung nach einem der Ansprüche 2 oder 3, wobei die Steuerung angepasst ist, um die Multiplexadresse ($AX(q)$) für einen aktuellen Zählerwert ($q$) abhängig von dem Zeitversatz ($\Delta\tau_{i,j}$), der Anzahl der seriellen Abtastwerte ($N_i$) und der Anzahl $P$ der Abtastwerte pro Paket zu berechnen.

5. Synchronisationsvorrichtung nach Anspruch 4, wobei die Steuerung ferner einen Leseadressen-Halteindikator ($I_{AM}(q)$) für einen aktuellen Zählerwert ($q$) berechnet, basierend auf einem Vergleich zwischen einer Multiplexadresse *(AX(q)),* die für den aktuellen Zählerwert berechnet wurde, und einer Multiplexadresse ($AX(q-1)$), die für einen vorherigen Zählerwert berechnet wurde.

6. Synchronisationsvorrichtung nach Anspruch 5, wobei die Steuerung angepasst ist, um die Leseadresse ($AM(q)$) für den aktuellen Zählerwert ($q$) abhängig von der Anzahl der seriellen Abtastwerte, dem Halteindikator ($I_{AM}(q)$) für den aktuellen Zählerwert ($q$) und einer Leseadresse ($AM(q-1)$), die für den vorherigen Zählerwert berechnet wurde, zu berechnen.

7. Synchronisationssystem zwischen Kanälen eines Mehrkanalempfangssystems für Funksignale, wobei das Empfangssystem eine Gruppe von Kanälen zum Empfang von Funksignalen umfasst, wobei jeder Empfangskanal ($V_i$) eine Empfangskette umfasst, die ein elektrisches Signal am Eingang eines Analog-Digital-Wandlers ($8_i$) mit einer zugehörigen Abtastfrequenz ($Fe_i$) liefert, und ein Schnittstellenmodul ($10_i$), das am Ausgang des Analog-Digital-Wandlers ($4_i$) angeschlossen ist und ein Modul zur digitalen Signalverarbeitung ($12_i$), umfassend eine oder mehrere programmierbare digitale Komponenten, wobei das Schnittstellenmodul ($10_i$) angepasst ist, um Abtastwerte des digitalisierten Signals am Eingang des genannten Moduls zur digitalen Signalverarbeitung ($12_i$) parallel in Paketen zu liefern,
**dadurch gekennzeichnet, dass** jeder Empfangskanal ($V_i$) eine Synchronisationsvorrichtung ($26_i$) nach einem der Ansprüche 1 bis 6 aufweist.

8. Synchronisationssystem nach Anspruch 7, ferner umfassend ein Zählmodul (100), das angepasst ist, um jeder Synchronisationsvorrichtung von jedem Empfangskanal synchron einen Zählerwert zu liefern.

9. Synchronisationssystem zwischen Kanälen eines Mehrkanalempfangssystems für Funksignale, das in einer Synchronisationsvorrichtung (26;) implementiert ist, die angepasst ist, um in einen Empfangskanal eines Mehrkanalempfangssystems für Funksignale zwischen einem Schnittstellenmodul ($10_i$) und einem Modul zur digitalen Signalverarbeitung ($12_i$) eingefügt zu sein, wobei das Schnittstellenmodul angepasst ist, um digitalisierte Signalabtastwerte zu empfangen, die von einem Analog-Digital-Wandler mit einer eigenen Abtastfrequenz ($Fe_i$) stammen, und Pakete aus $P$ digitalisierten Signalabtastwerten mit einer ersten Frequenz ($Fe_i/P$) zu liefern, wobei das Verfahren **dadurch gekennzeichnet ist, dass** es Folgendes umfasst:

- Speichern, in einem Speicher, auf den durch unabhängige Zugriffe schreibend und lesend zugegriffen werden kann, in dem Eingangspakete von $P$ Abtastwerten des digitalisierten Signals gespeichert sind, die von dem Schnittstellenmodul ($10_i$) mit der ersten Frequenz ($Fe_i/P$) geliefert werden,
- Erlangen von ersten Paketen von $P$ Abtastwerten in einer ersten Gruppe von Registern ($23_i$), die mit ersten Paketen von $P$ Abtastwerten, die aus dem Speicher ($21_i$) gelesen werden, mit einer zweiten Frequenz ($F_T$) eingegeben werden, wobei jedes erste Paket von $P$ Abtastwerten an einer Leseadresse *(AM(q))* gelesen wird, und
- Erlangen von zweiten Paketen von *P Abtastwerten* in einer zweiten Gruppe von Registern ($25_i$), die am Eingang von den Ausgängen der ersten Gruppe von Registern gespeist werden und angepasst sind, um zweite Pakete von $P$ Abtastwerten im Rhythmus der zweiten Frequenz ($F_T$) zu liefern, wobei ein zweites Paket von $P$ Abtastwerten den Abtastwerten des ersten Pakets von *P Abtastwerten* mit einer Verzögerung um eine Periode der zweiten Frequenz ($F_T$) entspricht.

10. Synchronisationsverfahren nach Anspruch 9, ferner umfassend die folgenden Schritte:

- Empfangen und Speichern eines anzuwendenden Zeitversatzes,
- Erlangen eines aktuellen Zählerwerts und Berechnen einer aktuellen Leseadresse *(AM(q))* und einer aktuellen Multiplexadresse *(AX(q))* abhängig von dem aktuellen Zählerwert und dem anzuwendenden Zeitversatz,
- Erlangen eines sogenannten ersten Pakets von Abtastwerten aus einer ersten Gruppe von Registern und eines sogenannten zweiten Pakets von Abtastwerten aus einer zweiten Gruppe von Registern durch Anwenden der aktuellen Leseadresse (*AM(q)*),
- extrahieren eines dritten Pakets von $P$ aufeinanderfolgenden Abtastwerten aus einem Doppelpaket von $2P$ Abtastwerten, das aus dem ersten und zweiten Paket gebildet wird, unter Verwendung der Multiplexadresse (*AX(q)*).

## Claims

1. A synchronization device ($26_i$) suitable for being inserted into a reception channel of a multichannel radioelectric reception system between an interfacing module ($10_i$) and a digital processing module of the signal ($12_i$), the interfacing module being suitable for receiving digitized signal samples coming from an analog-digital converter having a specific sampling frequency ($Fe_i$) and for supplying packets of $P$ signal samples digitized at a first frequency ($Fe_i/P$), the device being **characterized in that** it includes:

- a memory ($21_i$) accessible in write and read modes by independent accesses, in which input packets of $P$ samples of the digitized signal are stored supplied by the interfacing module ($10_i$),
- a first set of registers ($23_i$) supplied as input with first packets of $P$ samples read in said memory ($21_i$), at a second frequency ($F_T$), each packet of $P$ samples being read at a reading address (*AM(q)*), and
- a second set of registers ($25_i$) supplied as input by the outputs of the first set of registers and suitable for delivering second packets of $P$ samples at the rhythm of the second frequency ($F_T$), a second packet of $P$ samples corresponding to the samples of the first packet of $P$ samples with a delay of a period of the second frequency ($F_T$).

2. The synchronization device according to claim 1, wherein:

the synchronization device is such that the outputs of the first and second sets of registers are connected at the input of a multiplexer ($27_i$) so as to provide double packets of $2P$ samples, the multiplexer ($27_i$) being suitable for forming a third packet of $P$ consecutive samples from among the $2P$ input samples of the multiplexer ($27_i$) from a multiplexing address (*AX(q)*),
the synchronization device further including a logic controller ($28_i$) suitable for computing said memory reading

($AM(q)$)) and multiplexing ($AX(q)$) addresses as a function of a counter ($q$) and a time shift relative to a reference reception channel ($\Delta\tau_{i,j}$),

the synchronization device supplying, as output, pluralities of third packets of $P$ samples forming successive series each including a number of samples in the series corresponding to a same duration, and each first sample of one said series of said reception channel temporally corresponding to the first sample of a corresponding series of the reference reception channel.

3. The synchronization device according to claim 2, wherein said logic controller has an associated period ($T_A$), computed based on said duration ($\Delta T$), said counter ($q$) being incremented synchronously between reception channels upon each logic controller period.

4. The synchronization device according to one of claims 2 or 3, wherein said logic controller is suitable for computing said multiplexing address ($AX(q)$) for a current counter value ($q$) as a function of said time shift ($\Delta\tau_{i,j}$), said number of samples in series ($N_i$) and the number $P$ of samples per packet.

5. The synchronization device according to claim 4, wherein said logic controller further computes a reading address maintenance indicator ($I_{AM}(q)$) for a current counter value ($q$), as a function of a comparison between a multiplexing address ($AX(q)$) computed for said current counter value, and a multiplexing address ($AX(q - 1)$) computed for a previous counter value.

6. The synchronization device according to claim 5, wherein said logic controller is suitable for computing said reading address ($AM(q)$)) for the current counter value ($q$) as a function of said number of samples in series, said maintenance indicator ($I_{AM}(q)$ ) for the current counter value ($q$) and a reading address ($AM(q - 1)$) computed for the previous counter value.

7. A synchronization system between reception channels of a multichannel reception system, the reception system including a set of radioelectric reception channels, each reception channel ($V_i$) including a reception chain delivering an analog electrical signal at the input of an analog-digital converter ($8_i$) having an associated sampling frequency ($Fe_i$), an interfacing module ($10_i$) connected at the output of said analog-digital converter ($4_i$) and a digital processing module ($12_i$) of the signal including one or several programmable digital components, the interfacing module ($10_i$) being suitable for supplying digitized signal samples at the input of said digital processing module of the signal ($12_i$) in parallel by packets,

**characterized in that** each reception channel ($V_i$) includes a synchronization device ($26_i$) according to one of claims 1 to 6.

8. The synchronization system according to claim 7, further including a counting module (100) suitable for supplying, in a synchronized manner, a counter value to each synchronization device of each reception channel.

9. A synchronization method between reception channels of a multichannel radioelectric reception system implemented in a synchronization device ($26_i$) suitable for being inserted into a reception channel of a multichannel radioelectric reception system between an interfacing module ($10_i$) and a digital processing module of the signal ($12_i$), the interfacing module being suitable for receiving digitized signal samples coming from an analog-digital converter having a specific sampling frequency ($Fe_i$) and supplying packets of $P$ signal samples digitized at a first frequency ($Fe_i/P$), the method being **characterized in that** it includes:

- storage in a memory accessible in write and read modes by independent accesses, in which input packets of $P$ samples of the digitized signal are stored supplied by the interfacing module ($10_i$) at the first frequency ($Fe_i/P$),
- obtaining first packets of $P$ samples in a first set of registers ($23_i$) supplied as input with first packets of $P$ samples read in said memory ($21_i$), at a first frequency ($F_T$), each first packet of $P$ samples being read at a reading address ($AM(q)$), and
- obtaining second packets of $P$ samples in a second set of registers ($25_i$) supplied as input by the outputs of the first set of registers and suitable for delivering second packets of $P$ samples at the rhythm of the second frequency ($F_T$), a second packet of $P$ samples corresponding to the samples of the first packet of $P$ samples with a delay of a period of the second frequency ($F_T$).

10. The synchronization method according to claim 9, further including the following steps:

- receiving and storing a time shift to be applied,

- obtaining a current counter value, and computing a current reading address ($AM(q)$)) and a current multiplexing address ($AX(q)$) as a function of the current counter value and the time shift to be applied,
- obtaining one said first packet of samples from a first set of registers and one said second packet of samples from a second set of registers by applying the current reading address ($AM(q)$)),
- extracting a third packet of P consecutive samples from a double packet of 2P samples formed by the first and second packets, using said multiplexing address $(AX(q))$.

## FIG.1

FIG.2

FIG.3

FIG.4

FIG.5

FIG.6

## FIG.7

## FIG.8

## FIG.9